# EUROPEAN PATENT APPLICATION

(11) **EP 4 761 530 A1**
(43) Date of publication of application: **17.06.2026**
(21) Application number: 24863295.2
(22) Date of filing: 09.09.2024
(51) Int. Cl.: H10H 29/10, H10H 20/85, H10H 20/851, H10H 20/855, H10H 20/841, H10H 20/857

(54) **LIGHT-EMITTING DEVICE**

(30) Priority: 07.09.2023 US 202363536956 P; 22.09.2023 US 202363539846 P; 19.10.2023 US 202363591460 P; 04.09.2024 US 202418824413
(71) Applicant: Seoul Viosys Co., Ltd., Ansan-si, Gyeonggi-do 15429 (KR)
(72) Inventor: LEE, Chung Hoon, Ansan-Si Gyeonggi-do 15429 (KR); CHA, Nam Goo, Ansan-Si Gyeonggi-do 15429 (KR)
(74) Representative: Stolmár & Partner Patentanwälte PartG mbB
(86) International application number: PCT/KR2024/013652
(87) International publication number: WO 2025/053716

(57) **Abstract**

Disclosed is a light emitting apparatus. The light emitting apparatus (100) includes a substrate (110), a plurality of emitters (E₁ to E_{N}) disposed on the substrate (110) and configured to emit light, at least one color-determining layer (122, 124, 126) disposed on the plurality of emitters (E₁ to E_{N}), and a barrier layer (130) surrounding the color-determining layer (122, 124, 126).

## Description

### [Technical Field]

The disclosed technology relates to a light emitting apparatus.

### [Background Art]

In recent years, nitride semiconductors have been widely used as a base material for light emitting devices, such as light emitting diodes. Since nitride semiconductors can have various energy band-gaps depending on the composition ratio of Group III elements, it is possible to realize light with various wavelengths by controlling the composition ratio of elements, such as Al, Ga, In, or others.

For an active layer, a multi-quantum well (MQW) structure may be used and an emission wavelength of a light emitting device may be determined according to the composition ratio of nitride semiconductors in well layers of the multi-quantum well structure.

Typically, a light emitting diode may be used in the form of a light emitting diode package, in which a light emitting diode chip is mounted on a substrate, such as a printed circuit board (PCB), which includes a wiring layer and an insulation layer.

The light emitting diode package is a light emitting apparatus and may be used in a display apparatus to display characters, symbols, images, videos, and the like. The display apparatus may include a plurality of light emitting apparatuses and may control light emitted from the plurality of light emitting apparatuses to display characters, symbols, images, videos, and the like.

The display apparatus includes a display substrate, such as a printed circuit board (PCB) and the like, on which electrical circuits are disposed, and a plurality of light emitting apparatuses disposed as a module on the display substrate.

### [Disclosure]

### [Technical Problem]

It is an aspect of the disclosed technology to provide a light emitting apparatus with improved luminous efficacy.

### [Technical Solution]

In accordance with one aspect of the disclosed technology, a light emitting apparatus (100) may include a substrate (110), a plurality of emitters (E₁ to E_{N}) disposed on the substrate (110) and configured to emit light, at least one color-determining layer (122, 124, 126) disposed on the plurality of emitters (E₁ to E_{N}), and a barrier layer (130) surrounding the color-determining layer (122, 124, 126).

In one embodiment, the barrier layer (130) may include at least one hole (H).

In one embodiment, the color-determining layer (122, 124, 126) may be placed within the hole H.

In one embodiment, the barrier layer (130) may include a plurality of holes (H) arranged in a grid pattern.

In one embodiment, the plurality of emitters (E₁ to E_{N}) may include a first emitter (E₁) configured to emit light in a first wavelength band, a second emitter (E₂) configured to emit light in a second wavelength band, and a third emitter (E₃) configured to emit light in a third wavelength band.

In one embodiment, the first to third emitters (E₁ to E₃) may be configured to generate light in a wavelength band of 350 nm to 500 nm and a difference in peak wavelength of light emitted from the first to third emitters (E₁ to E₃) may be less than or equal to 5 nm.

In one embodiment, each of the first to third emitters (E₁ to E₃) may include a first conductivity type semiconductor layer, a second conductivity type semiconductor layer, and an active layer interposed between the first conductivity type semiconductor layer and the second conductivity type semiconductor layer.

In one embodiment, well layers of each of the active layers may include the same material.

In one embodiment, the color-determining layer (122, 124, 126) may include a first color-determining layer (122) disposed on the first emitter (E₁), a second color-determining layer (124) disposed on the second emitter (E₂), and a third color-determining layer (126) disposed on the third emitter (E₃).

In one embodiment, at least one of the first to third color-determining layers (122, 124, 126) may include a wavelength conversion material.

In one embodiment, at least one of the first to third color-determining layers (122, 124, 126) may be a transparent light-transmitting layer.

In one embodiment, an upper surface of the color-determining layer (122, 124, 126) may be flush with an adjacent upper surface of the barrier layer (130).

In one embodiment, a width (W1) of the barrier layer (130) may be less than a horizontal width (W2) of the adjacent color-determining layer (122, 124, 126).

In one embodiment, the barrier layer (130) may include a first barrier layer (132) and a second barrier layer (134) disposed under the first barrier layer (132) and having a vertical height (H12) greater than a vertical height (H11) of the first barrier layer (132).

In one embodiment, a width (W12) of the second barrier layer (134) may be less than a width (W11) of the first barrier layer (132).

In one embodiment, the first barrier layer (132) may include the same material as the second barrier layer (134).

In one embodiment, the barrier layer (130) may further include a third barrier layer (136) disposed between the first barrier layer (132) and the color-determining layer (122, 124, 126).

In one embodiment, the third barrier layer (136) may be a metallic reflective layer.

In one embodiment, the light emitting apparatus may further include a buffer layer (140) disposed between the plurality of emitters (E₁ to E_{N}) and the color-determining layer (122, 124, 126).

In one embodiment, a portion of the buffer layer (140) may be disposed between the color-determining layer (122, 124, 126) and the barrier layer (130).

In one embodiment, the light emitting apparatus may further include an ohmic electrode (150) disposed on one surface of each of the first to third emitters (E1 to E3) facing the substrate (110), wherein each of the ohmic electrodes (150) may have the same shape or similar shapes.

In accordance with another aspect of the disclosed technology, a light emitting apparatus (100) may include: a substrate (110); a plurality of lower emitters (D₁ to D_{N}) disposed on the substrate (110) and configured to emit light, at least one upper emitter (U₁ to U_{M}) disposed on the lower emitters (D₁ to D_{N}) and configured to emit light, and at least one color-determining layer (122, 124, 126) disposed on the plurality of lower emitters (D₁ to D_{N}), and a barrier layer (130) surrounding the color-determining layer (122, 124, 126).

In one embodiment, the upper emitter (U₁ to U_{M}) may be configured to emit light in a wavelength band having a different peak wavelength than the plurality of lower emitters (D₁ to D_{N}).

### [Advantageous Effects]

The disclosed technology may provide a light emitting apparatus with improved luminous efficacy.

### [Description of Drawings]

FIG. 1 is a cross-sectional view of a light emitting apparatus according to one embodiment of the disclosed technology.
FIG. 2 is a partial plan view of the light emitting apparatus shown in FIG. 1.
FIG. 3 is a cross-sectional view of a light emitting apparatus according to another embodiment of the disclosed technology.
FIG. 4 is a cross-sectional view of a light emitting apparatus according to a further embodiment of the disclosed technology.
FIG. 5 is a cross-sectional view of a light emitting apparatus according to yet another embodiment of the disclosed technology.
FIG. 6 is a cross-sectional view of a light emitting apparatus according to yet another embodiment of the disclosed technology.
FIG. 7 is a plan view of a light emitting apparatus according to yet another embodiment of the disclosed technology.
FIG. 8 is a cross-sectional view taken along line I-I' of FIG. 7.
FIG. 9 is a plan view of a light emitting apparatus according to yet another embodiment of the disclosed technology.
FIG. 10A is a cross-sectional view taken long line II-II' of FIG. 9 and FIG. 10B is a cross-sectional view taken along line III-III' of FIG. 9.

### [Best Mode]

In the following description, for the purposes of explanation, numerous specific details are set forth in order to provide thorough understanding of various exemplary embodiments or implementations of the present disclosure. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), and the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

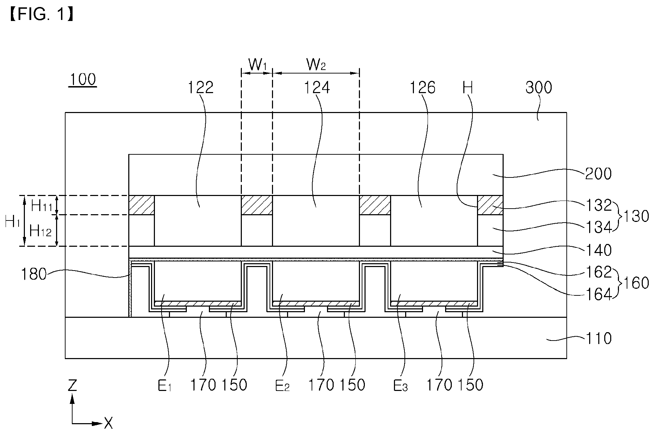

FIG. 1 is a cross-sectional view of a light emitting apparatus 100 according to a first embodiment of the disclosed technology. The light emitting apparatus 100 includes a substrate 110, a plurality of emitters E₁ to E_{N} disposed on the substrate 110 and configured to emit light, at least one color-determining layer 122, 124, 126 disposed on the plurality of emitters E₁ to E_{N}, and a barrier layer 130 surrounding the color-determining layer 122, 124, 126.

The substrate 110 is a substrate on which the emitters E₁ to E_{N} are mounted, and may have various configurations. The emitters E₁ to E_{N} are mounted on an upper surface of the substrate 110, and the substrate 110 may be selected from any type of substrate, such as a circuit board or lead frame, a flexible substrate, a transparent substrate, so long as the substrate can support the emitters E₁ to E_{N}.

For example, the substrate 110 may be composed of any one of supportable materials, such as a printed circuit board (PCB), a TFT, or a transparent substrate. The PCB may be, for example, an FR4 PCB, which has good properties in terms of high strength, flame retardancy, chemical resistance, or others. Alternatively, the PCB may be a metal PCB, which exhibits good heat dissipation performance and good thermal conductivity. More specifically, the PCB may be a PCB including Cu, Zn, Au, Ni, Al, Mg, Cd, Be, W, Mo, Si, Fe, or an alloy of at least one of these metals as a base metal. However, it should be understood that the disclosed technology is not limited thereto and various PCBs may be used depending on characteristics of final products.

The substrate 110 may have an insulation layer and interconnections for electrical connection with the emitters E₁ to E_{N}, and may include circuitry for power supply of an electrical source, such as current or voltage, to the emitters E₁ to E_{N} to drive the emitters E₁ to E_{N}.

The substrate 110 may be formed on an upper surface thereof with electrode pads for mounting the emitters E₁ to E_{N}, and on a lower surface thereof with a pad to be mounted on another substrate (for example, a display substrate).

The substrate 110 may have a monolayer or multilayer structure and may be formed to various thicknesses, as needed. The substrate 110 may be a display substrate constituting a display apparatus or may be a base substrate to be mounted on the display substrate.

The plurality of emitters E₁ to E_{N} may be disposed on one surface of the substrate 110. The plurality of emitters E₁ to E_{N} may be connected to the electrical circuitry of the substrate 110 through a conductive material or an adhesive material. For example, the plurality of emitters E₁ to E_{N} may be connected to the electrical circuitry of the substrate 110 by soldering.

The plurality of emitters E₁ to E_{N} may include light emitting structures disposed on the substrate 110 and configured to emit light. Although FIG. 1 shows the light emitting apparatus 100 including three emitters E₁ to E₃, it should be understood that the disclosed technology is not limited thereto and may include a greater number of emitters E₁ to E_{N} on the substrate.

The plurality of emitters E₁ to E_{N} may be spaced apart from each other and may be arranged in various patterns, such as a grid pattern, a linear arrangement, or others. The plurality of emitters E₁ to E_{N} may be driven independently of each other to emit light.

As the light emitting structure, each of the emitters E₁ to E_{N} may include a first conductivity type semiconductor layer, an active layer, and a second conductivity type semiconductor layer.

The first conductivity type semiconductor layer is a semiconductor layer disposed on one side of the substrate and may further include a buffer layer. The buffer layer may include a nitride or phosphide semiconductor, such as GaN, GaAs, or others, and may be grown through metal organic chemical vapor deposition (MOCVD).

The first conductivity type semiconductor layer may include a phosphide or nitride semiconductor, such as (Al, Ga, In)P or (Al, Ga, In)N, and may be formed on a growth substrate by a method, such as MOCVD, MBE, or HVPE. Further, the first conductivity type semiconductor layer may be doped with at least one type of n-type dopant, such as Si, C, Ge, Sn, Te, Pb, or others. However, it should be understood that the disclosed technology is not limited thereto and the first conductivity type semiconductor layer may also be doped with a p-type dopant to become an opposite conductivity type.

In addition, the first conductivity type semiconductor layer may be composed of a single layer or multiple layers. For example, the first conductivity type semiconductor layer may include a first sub-conductivity type semiconductor layer and a second sub-conductivity type semiconductor layer disposed on the first sub-conductivity type semiconductor layer.

The first sub-conductivity type semiconductor layer and the second sub-conductivity type semiconductor layer may be doped at different concentrations and may be formed at different process temperatures. When the first conductivity type semiconductor layer is composed of multiple layers, the first conductivity type semiconductor layer may include a superlattice layer. Furthermore, the first conductivity type semiconductor layer may further include a contact layer, a modulation doping layer, an electron implantation layer, or others.

The active layer refers to a light emitting layer interposed between the first conductivity type semiconductor layer and the second conductivity type semiconductor layer, may include a phosphide or nitride semiconductor, such as (Al, Ga, In)P or (Al, Ga, In)N, and may be grown by a technique, such as MOCVD, MBE, or HVPE.

The active layer may include a quantum well structure (QW) including at least two barrier layers and at least one well layer. Alternatively, the active layer may include a multi-quantum well structure (MQW) including a plurality of barrier layers and a plurality of well layers.

The wavelength of light emitted from the active layer may be adjusted by controlling a composition ratio of materials constituting the well layer. Here, the well layers may have the same element in common and may include indium (In)
The well layer is disposed between the barrier layers and has a narrower energy bandgap than the barrier layers. The well layer may include or be formed of InₓGa₍₁₋ₓ₎N or InₓGa₍₁₋ₓ₎P (0 < x < 1), in which the wavelength of light emitted from the active layer may be adjusted according to the composition ratio (x) of In. The barrier layers and the well layers are alternately stacked one above another, preferably alternately stacked at least twice. A barrier layer and a well layer adjacent thereto may constitute a pair

Alternatively, the active layers of the plurality of emitters E₁ to E_{N} may be free from indium.

The well layers of each of the emitters E₁ to E_{N} may be formed of the same or different materials and may have the same or different compositions.

The second conductivity type semiconductor layer may include a phosphide or nitride semiconductor, such as (Al, Ga, In)P or (Al, Ga, In)N, and may be grown through a technique, such as MOCVD, MBE, or HVPE. The second conductivity type semiconductor layer may be doped to become a conductivity type opposite to the conductivity type of the first conductivity type semiconductor layer. For example, the second conductivity type semiconductor layer may be doped with p-type dopants, such as Mg.

The second conductivity type semiconductor layer may have a monolayer structure having a composition, such as p-GaN, and may further include an AlGaN layer therein, without being limited thereto.

In the plurality of emitters E₁ to E_{N}, the doping concentrations of the first conductivity type semiconductor layers may be the same or similar to each other. A difference in doping concentration between the first conductivity type semiconductor layers of the plurality of emitters E₁ to E_{N} may be within 20%. The doping concentrations of the second conductivity type semiconductor layers of the plurality of emitters E₁ to E_{N} may be the same or similar to each other. A difference in doping concentration between the second conductivity type semiconductor layers of the plurality of emitters E₁ to E_{N} may be within 20%.

The plurality of emitters E₁ to E_{N} may emit light with peak wavelengths having a difference of 5 nm or less therebetween. In another example, at least one of the plurality of emitters E₁ to E_{N} may emit light with a different peak wavelength.

Referring to FIG. 1, a first emitter E₁ may emit light having a first peak wavelength, a second emitter E₂ may emit light having a second peak wavelength, and a third emitter E₃ may emit light having a third peak wavelength. The first to third peak wavelengths may be the same or different from one another.

By way of example, the first to third emitters E₁ to E₃ may emit light in a wavelength band of 350 nm to 500 nm. Here, the first to third emitters E₁ to E₃ may emit blue light or ultraviolet light.

A difference in peak wavelength of light emitted from the plurality of emitters E₁ to E_{N} may be less than or equal to 5 nm. A difference in indium content between the active layers of the plurality of emitters E₁ to E_{N} may be less than or equal to 5%.

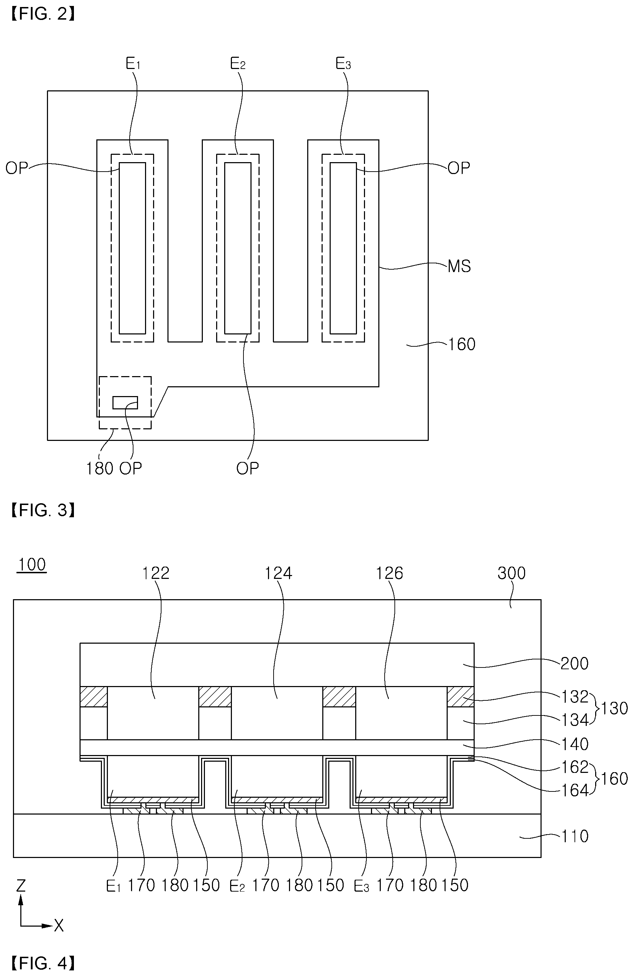

Referring now to FIG. 2, the plurality of emitters E₁ to E_{N} may be formed by a mesa MS, which is formed by partially etching the second conductivity type semiconductor layer so as to expose the upper surface of the first conductivity type semiconductor layer. Each of the emitters E₁ to E_{N} may be isolated from one another and may be driven through the mesa structure.

The light emitting apparatus 100 may further include an ohmic electrode 150 disposed on one surface of each of the plurality of emitters E₁ to E_{N}. The ohmic electrodes 150 may be transparent electrodes, such as ITO, IZO, or others. Additionally, the ohmic electrodes 150 may include a light-reflective metallic material. Here, the surfaces of the emitters E₁ to E_{N} on which the ohmic electrodes 150 are disposed may face the substrate 110. For example, as the second conductivity type semiconductor layer of each of the emitters E₁ to E_{N} constitutes one surface facing the substrate 110, the ohmic electrode 150 may be disposed on the one surface of the second conductivity type semiconductor layer. Alternatively, as the first conductivity type semiconductor layer of each of the emitters E₁ to E_{N} constitutes one surface facing the substrate 110, the ohmic electrode 150 may be disposed on the one surface of the first conductivity type semiconductor layer.

The ohmic electrodes 150 disposed on the respective emitters E₁ to E_{N} may be formed of the same material. In addition, the ohmic electrodes 150 may have the same or similar shapes. Further, the areas of the ohmic electrodes 150 may have a deviation in the range of 90% to 110%. This structure can reduce a difference in specific resistance of electrodes of the emitters E₁ to E_{N}, thereby preventing difference in luminous efficacy. The ohmic electrodes 150 may be spaced apart from each other and may be arranged corresponding to arrangement of the emitters E₁ to E_{N}. This structure can increase a difference in transmittance between regions where the emitters E₁ to E_{N} are disposed and a region where the emitters E₁ to E_{N} are not disposed.

In addition, the light emitting apparatus 100 may further include a protective layer 160 covering the ohmic electrodes 150. The protective layer 160 may include at least one of SiO₂, TiO₂, a resin, a silicone, an epoxy molding compound (EMC), or others.

The protective layer 160 may include a distributed Bragg reflector (DBR).

The protective layer 160 may include a plurality of openings (OP) that partially expose each of the ohmic electrodes 150. When the protective layer 160 is formed prior to the ohmic electrodes 150, the openings OP in the protective layer 160 may expose the semiconductor layers of the emitters E₁ to E_{N}. An external electrical source may be supplied to the plurality of emitters E₁ to E_{N} through the openings OP. The openings OP corresponding to the emitters E₁ to E_{N} may be disposed to overlap centers of the emitters E₁ to E_{N}. Alternatively, the semiconductor layer regions of the emitters E₁ to E_{N} exposed through the openings OP may overlap the centers of the emitters E₁ to E_{N}. Alternatively, the openings OP of the protective layer 160 may overlap the centers of the ohmic electrodes 150, respectively. This structure enables uniform current injection and concentration of light into the central regions of the emitters E₁ to E_{N}.

The protective layer 160 may have a monolayer structure, without being limited thereto, and may include a plurality of sub-protective layers 162, 164, as shown in FIG. 1. For example, the protective layer 160 may include a first sub-protective layer 162 covering the ohmic electrode 150 and a second sub-protective layer 164 disposed on the first sub-protective layer 162.

The first sub-protective layer 162 may include at least one of SiO₂, TiO₂, and a distributed Bragg reflector, and the second sub-protective layer 164 may be a coating layer, for example, a polyimide (PI) coating layer or a silsesquioxane (SSQ) coating layer.

The ohmic electrodes 150 may be exposed through the openings OP of the first sub-protective layer 162 and the second sub-protective layer 164. In addition, the upper surface of the first conductivity type semiconductor layer etched by the mesa MS may be partially exposed through the openings OP of the first sub-protective layer 162 and the second sub-protective layer 164.

The light emitting apparatus 100 may include first and second electrode pads 170, 180 electrically connected to the first conductivity type semiconductor layer and the second conductivity type semiconductor layer of each of the emitters E₁ to E_{N}, respectively.

The second electrode pad 170 may be electrically connected to the second conductivity type semiconductor layer through the ohmic electrode 150 exposed through the opening OP.

Although the second electrode pad 170 is shown as being separately provided for each of the emitters E₁ to E_{N} in FIG. 1, it should be understood that the disclosed technology is not limited thereto. Alternatively, the second electrode pad 170 may be formed as a single member configured to electrically connect the plurality of emitters E₁ to E_{N} to each other.

The first electrode pad 180 may be electrically connected to the first conductivity type semiconductor layer exposed through the opening OP in the protective layer 160. The first electrode pad 180 may be separately provided for each of the emitters E₁ to E_{N}. Alternatively, the first electrode pad 180 may be formed as a single member configured to electrically connect the plurality of emitters E₁ to E_{N} to each other.

Accordingly, at least one of the first conductivity type semiconductor layers or the second conductivity type semiconductor layers of the plurality of emitters E₁ to E_{1N} may be connected to each other.

The light emitting apparatus 100 may include the first electrode pad 180 connecting the emitters E₁ to E_{N} to each other, in which the first electrode pad 180 may be disposed at a location opposite to the ohmic electrodes 150 of the emitters E₁ to E_{N}. Referring to FIG. 1, in cross-sectional view, the first electrode pad 180 may have a greater horizontal distance than one ohmic electrode 150. The horizontal distance of the first electrode pad 180 may be greater than a horizontal distance of one emitter E₁ to E_{N}. Accordingly, the first electrode pad 180 can be stably connected to the emitters E₁ to E_{N}.

In plan view, the first electrode pad 180 may be formed to pass by one surface of each of the emitters E₁ to E_{N} and a region between the emitters E₁ to E_{N}. Alternatively, the first electrode pad 180 may define an opening overlapping the region between the emitters E₁ to E_{N} and may surround the opening. The first electrode pad 180 may be formed in a mesh shape.

The first electrode pad 180 may include a main region connected to the emitters E₁ to E_{N} and an extension region extending from the main region toward the substrate 110. Thus, the first electrode pad 180 may include a bent portion between the main region and the extension region. Accordingly, even though the main region connected to the emitters E₁ to E_{N} is spaced apart from the substrate 110, the main region may be electrically connected to the electrodes on the substrate 110.

Light emitted from the emitters E₁ to E_{N} may pass through the first electrode pad 180 and the transmitted light having passed through the first electrode pad 180 may be incident on color-determining layers 122, 124, 126 described below.

The first and second electrode pads 170, 180 may at least partially cover the protective layer 160. The first and second electrode pads 170, 180 may deliver an externally supplied electrical source to the plurality of emitters E₁ to E_{N}.

Light emitted from each of the plurality of emitters E₁ to E_{N} may have an energy bandgap. The plurality of emitters E₁ to E_{N} may form a single pixel PX in the display apparatus.

The color-determining layers 122, 124, 126 may be disposed on the plurality of emitters E₁ to E_{N}. The color-determining layer 122, 124 or 126 may be provided singularly or in plural. Specifically, the number of color-determining layers 122, 124, 126 may be the same as the number of emitters E₁ to E_{N}. Here, the color-determining layers 122, 124, 126 may correspond to the emitters E₁ to E_{N}, which are formed under the color-determining layers 122, 124, 126, respectively. Light emitted from the emitters E₁ to E_{N} may be emitted to the outside after passing through the corresponding color-determining layers 122, 124, 126.

For the light emitting apparatus including a plurality of color-determining layers 122, 124, 126, at least one of the color-determining layers 122, 124, 126 may include a wavelength conversion material. The wavelength conversion material may have various configurations, such as phosphor particles, quantum dots, or others. The wavelength conversion material may have a particle size of 10 µm or less, without being limited thereto. Alternatively, the wavelength conversion material may have a particle size of 10 µm or more in consideration of photo-conversion efficiency.

The color-determining layers 122, 124, 126 may be spaced apart from each other in the horizontal direction.

Light transmitted through the different color-determining layers 122, 124, 126 may have different peak wavelengths.

At least one of the color-determining layers 122, 124, 126 may be a transparent light-transmitting layer. That is, at least one of the color-determining layers 122, 124, 126 may be a transparent layer that does not contain a wavelength conversion material. The light having passed through the color-determining layer 122, 124, 126 not containing the wavelength conversion material may be emitted to the outside without being subjected to any wavelength conversion before and after passing therethrough.

For example, referring to FIG. 1, the color-determining layers 122, 124, 126 may include a first color-determining layer 122 disposed on the first emitter E₁, a second color-determining layer 124 disposed on the second emitter E₂, and a third color-determining layer 126 disposed on the third emitter E₃.

Light emitted from the first emitter E₁ may be emitted to the outside after passing through the first color-determining layer 122. Light emitted from the second emitter E₂ may be emitted to the outside after passing through the second color-determining layer 124. Light emitted from the third emitter E₃ may be emitted to the outside after passing through the third color-determining layer 126.

At least one of the first to third color-determining layers 122, 124, 126 may include a wavelength conversion material. For example, the first to third color-determining layers 122, 124, 126 may include at least one same material. Alternatively, at least one of the first to third color-determining layers 122, 124, 126 may include at least one different material than the other color-determining layers 122, 124, 126.

Further, at least one of the first to third color-determining layers 122, 124, 126 may be a transparent light-transmitting layer. For example, the first and second color-determining layers 122, 124 may include the wavelength conversion material and the third color-determining layer 126 may be a transparent light-transmitting layer that does not contain the wavelength conversion material. In this case, the wavelength conversion materials included in the first and second color-determining layers 122, 124 may be different or the same.

As the first color-determining layer 122 through which light emitted from the first emitter E1 passes includes the wavelength conversion material, the number of peaks of light having passed through the first color-determining layer 122 may be greater than the number of peaks of the light emitted from the first emitter E₁. Similarly, as the second color-determining layer 124 through which light emitted from the second emitter E₂ passes includes the wavelength conversion material, the number of peaks of light having passed through the second color-determining layer 124 may be greater than the number of peaks of the light emitted from the second emitter E₂. On the other hand, as the third color-determining layer 126 through which light emitted from the third emitter E₃ passes does not include the wavelength conversion material, the number of peaks of the light emitted from the third emitter E₃ may be the same as the number of peaks of light having passed through the third color-determining layer 126.

Each of the color-determining layers 122, 124, 126 may have a width W₂ in the horizontal direction. The width W₂ of the color-determining layers 122, 124, 126 may be the same as or different from the width of the corresponding emitters E₁ to E₃ under the color-determining layers. For example, the width W₂ of the color-determining layers 122, 124, 126 may be greater than the width of the corresponding emitters E₁ to E₃. Since the barrier layer 130 described below is interposed between the color-determining layers 122, 124, 126, the width W2 of the color-determining layers 122, 124, 126 can prevent light leakage through the barrier layer 130 even when the widths of the corresponding emitters E₁ to E₃ under the color-determining layers 122, 124, 126 are different.

The barrier layer 130 refers to a sidewall structure surrounding the color-determining layers 122, 124, 126 and may have various configurations.

The barrier layer 130 is a sidewall structure interposed between adjacent color-determining layers 122, 124, 126 and can prevent light emitted through a side surface of each color-determining layer 122, 124, 126 from affecting other color-determining layers 122, 124, 126 adjacent thereto.

An upper surface of each of the color-determining layers 122, 124, 126 may be flush with an upper surface of the adjacent barrier layer 130.

A width W₁ of the barrier layer 130 may be less than the horizontal width W₂ of the adjacent color-determining layers 122, 124, 126.

Here, the width W₁ of the barrier layer 130 may refer to a width of the barrier layer 130 interposed between the color-determining layers 122, 124, 126 constituting one pixel PX.

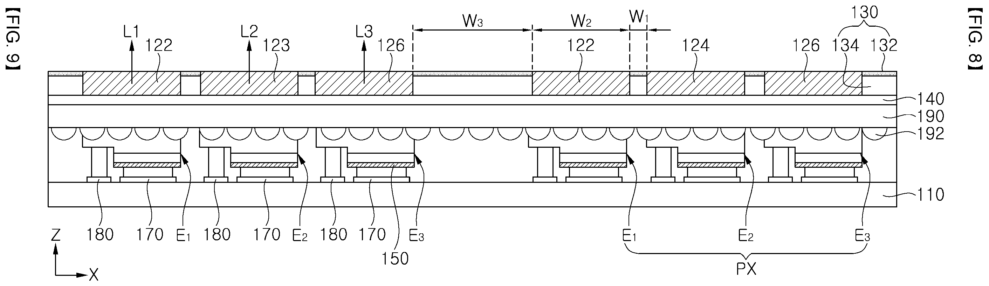

Referring to FIG. 8, a width W₃ of the barrier layer 130 disposed between different pixels PX may be greater than the width W₁. The width W₃ may also be greater than the horizontal width W₂ of the color-determining layers 122, 124, 126.

Meanwhile, the barrier layer 130 may include at least one of a resin, a silicone, a polyimide, a black matrix, or others. Further, the barrier layer 130 may include a light blocking material.

The barrier layer 130 may be disposed to surround the color-determining layers 122, 124, 126. The barrier layer 130 may be formed in the form of a sheet including at least one hole H. Here, the color-determining layers 122, 124, 126 may be placed within the holes H of the barrier layer 130, respectively.

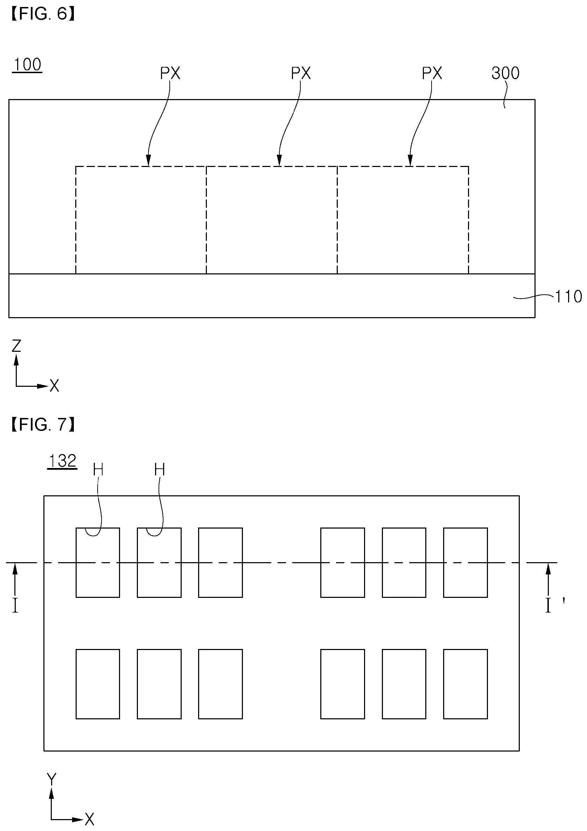

For example, the barrier layer 130 may include a plurality of holes H, as shown in FIG. 7. The plurality of holes H may be arranged in various patterns. For example, the plurality of holes H may be arranged in a grid pattern of an N×M matrix, where each of N and M is a natural number greater than or equal to 1. A separation distance between adjacent holes H may be set in various ways.

Since the barrier layer 130 includes the plurality of holes H, the barrier layer 130 may be formed as a net or net-like shape in plan view.

Corresponding to the holes H of the barrier layer 130, the color-determining layers 122, 124, 126 may be disposed within the holes H, respectively.

An overall vertical height H₁ of the barrier layer 130 may be less than or equal to vertical heights of the color-determining layers 122, 124, 126.

The barrier layer 130 may be composed of a single layer or may have a multilayer structure, as shown in FIG. 1, which includes a first barrier layer 132 and a second barrier layer 134 disposed under the first barrier layer 132. Although not shown in the drawings, the barrier layer 130 may further include an additional barrier layer under the second barrier layer 134.

The first barrier layer 132 may have the same configuration as or a similar configuration to the barrier layer 130 described above. A vertical height H₁₁ of the first barrier layer 132 may be less than the heights of the color-determining layers 122, 124, 126.

The second barrier layer 134 may have a vertical height H₁₂ greater than the vertical height H₁₁ of the first barrier layer 132.

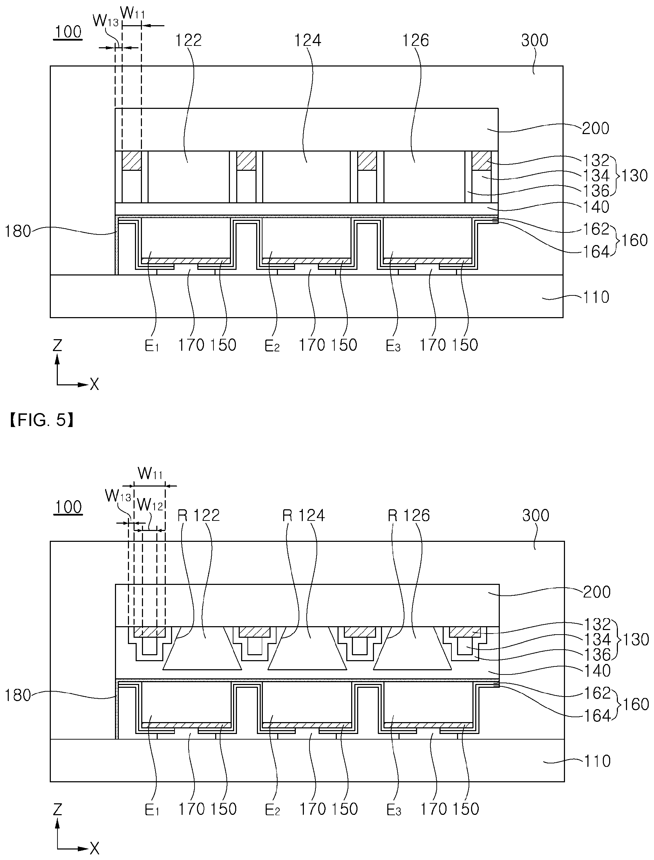

Although FIG. 1 to FIG. 4 illustrate an example in which the width of the second barrier layer 134 and the width of the first barrier layer 132 in the horizontal direction are equal to W₁, it should be understood that the disclosed technology is not limited thereto. For example, referring to FIG. 5, a width W₁₂ of the second barrier layer 134 may be less than a width W₁₁ of the first barrier layer 132.

The second barrier layer 134 may include at least one of a resin, a silicone, a polyimide, an epoxy molding compound (EMC), or others. The first barrier layer 132 may include the same material as the second barrier layer 134.

The first barrier layer 132 and the second barrier layer 134 may have different light transmittances. In addition, the first barrier layer 132 and the second barrier layer 134 may have different melting points. Further, the first barrier layer 132 and the second barrier layer 134 may have different thermal conductivities. Accordingly, the light emitting apparatus 100 can reduce thermal stress applied to the first barrier layer 132 and the second barrier layer 134 due to heat from inside or outside the light emitting apparatus 100.

In another embodiment, referring to FIG. 4, the barrier layer 130 may further include a third barrier layer 136 disposed between the first barrier layer 132 and the color-determining layers 122, 124, 126.

The third barrier layer 136 may cover a side surface of at least one of the first barrier layer 132 or the second barrier layer 134.

The third barrier layer 136 may include at least one of SiO₂, TiO₂, a resin, a silicone, a polyimide, an epoxy molding compound (EMC), a metallic material, or others.

In addition, the third barrier layer 136 may be a distributed Bragg reflector (DBR). For example, the third barrier layer 136 may be a metal reflective layer.

The third barrier layer 136 may have a different thermal conductivity than the first barrier layer 132 and the second barrier layer 134. For example, the thermal conductivity of the third barrier layer 136 may be higher than the thermal conductivities of the first barrier layer 132 and the second barrier layer 134.

Referring to FIG. 4, a cross-sectional width W₁₃ of the third barrier layer 136 may be less than the widths W₁₁, W₁₂ of the first barrier layer 132 and the second barrier layer 134.

The third barrier layer 136 may extend from a side surface of the first barrier layer 132 to a side surface of the second barrier layer 134. The first barrier layer 132 and the second barrier layer 134 may be covered by the third barrier layer 136, thereby preventing edges of the first barrier layer 132 and the second barrier layer 134 from delamination.

The light emitting apparatus 100 may further include a buffer layer 140 disposed between the plurality of emitters E₁ to E_{N} and the color-determining layers 122, 124, 126.

The buffer layer 140 may cover upper surfaces of the plurality of emitters E₁ to E_{N} and lower surfaces of the color-determining layers 122, 124, 126.

Furthermore, the buffer layer 140 may be partially disposed between the color-determining layers 122, 124, 126 and the barrier layer 130, as shown in FIG. 5. That is, the buffer layer 140 may partially extend into regions between the color-determining layers 122, 124, 126 and the barrier layer 130. Accordingly, it is possible to ensure that the emitters E₁ to E_{N} are firmly bonded to materials disposed thereon.

The buffer layer 140 may include at least one of a resin, a silicone, a polyimide, or others.

The light emitting apparatus 100 may further include a supporter 200 disposed on the color-determining layers 122, 124, 126. Here, the buffer layer 140 may extend to one surface of the supporter 200 and may cover at least a region of the supporter 200. The supporter 200 is not an essential component and may be optionally added.

In addition, the light emitting apparatus 100 may further include a light transmitting layer 300 disposed thereon. The light transmitting layer 300 may be formed of a light transmissive material. For example, the light transmitting layer 300 may be formed of any material capable of transmitting light, such as a resin, a silicone, a polyimide, glass, sapphire, or others.

Specifically, FIG. 1 illustrates the light emitting apparatus 100 according to the first embodiment of the disclosed technology, wherein the barrier layer 130 may include the first and second barrier layers 132, 134. Referring to FIG. 1, the second electrode pads 170 may be disposed on the emitters E₁ to E₃, respectively. Referring to FIG. 2, the first electrode pad 180 may be provided as a common electrode to the emitters E₁ to E₃. It will be apparent that the number, shape, and arrangement of the first and second electrode pads 170, 180 may be modified in various ways.

FIG. 3 shows a variation of the first embodiment of FIG. 1, which may have the same configuration as or a similar configuration to the first embodiment except that each of the emitters E₁ to E₃ is provided with the first and second electrode pads 170, 180.

FIG. 4 shows a light emitting apparatus 100 according to a second embodiment of the disclosed technology, which may have the same configuration as or a similar configuration to the first embodiment except that the barrier layer 130 further includes a third barrier layer 136.

FIG. 5 shows a light emitting apparatus 100 according to a third embodiment of the disclosed technology, which may have the same configuration as or a similar configuration to the first embodiment except that the barrier layer 130 further includes a third barrier layer 136 covering the first barrier layer 132 and the second barrier layer 134 and a buffer layer 140 extends to regions between the barrier layer 130 and the color-determining layers 122, 124, 126.

Furthermore, as shown in FIG. 5, each of the color-determining layers 122, 124, 126 may have slopes on opposite sides thereof. Accordingly, each of the color-determining layers 122, 124, 126 may have a trapezoidal cross-section. The shape of the color-determining layers 122, 124, 126 may also be applied to the light emitting apparatus 100 according to the first or second embodiment.

Although FIG. 1 to FIG. 5 illustrate the embodiments in which the light emitting apparatus 100 includes three emitters E₁ to E₃, it should be understood that the disclosed technology is not limited thereto and the light emitting apparatus 100 may include a greater number of emitters E₁ to E_{N}, as shown in FIG. 8.

Further, as shown in FIG. 6, when the three emitters E₁ to E₃ and the color-determining layers 122, 124, 126 constitute one pixel PX, the light emitting apparatus 100 may include a plurality of pixels PX on the substrate 110.

Specifically, FIG. 8 shows a light emitting apparatus 100 according to a fourth embodiment, which includes four pixels PX when the three emitters E₁ to E₃ and the color-determining layers 122, 124, 126 constitute one pixel PX. In the light emitting apparatus 100 shown in FIG. 8, the first barrier layer 132 include 12 holes H, which are arranged in a grid pattern, as shown in FIG. 7, and the corresponding color-determining layer 122, 124, 126 may be disposed in each of the holes H.

In FIG. 8, each of the emitters E₁ to E₃ may be disposed on a growth substrate 190 and protrusions 190 may be formed on one surface of the growth substrate 190, which faces the emitters E₁ to E₃. The protrusions 190 can increase extraction efficiency of light emitted from the emitters E₁ to E₃ through the structure thereof.

Light emitted from the first emitter E₁ may pass through the first color-determining layer 122 and transmitted light L1 having passed through the first color-determining layer 122 may be emitted to the outside. The transmitted light L1 may be a mixture of the light emitted from the first emitter E₁ and the light excited through the first color-determining layer 122. The transmitted light L1 may have a greater number of peak wavelength than the light emitted from the first emitter E₁.

Light emitted from the second emitter E₂ may pass through the second color-determining layer 124 and transmitted light L2 having passed through the second color-determining layer 124 may be emitted to the outside. The transmitted light L2 may be a mixture of the light emitted from the second emitter E₂ and the light excited through the second color-determining layer 124. The transmitted light L2 may have a greater number of peak wavelength than the light emitted from the second emitter E₂.

Light emitted from the third emitter E₃ may pass through the third color-determining layer 126 and transmitted light L3 having passed through the third color-determining layer 126 may be emitted to the outside. The transmitted light L3 may be a mixture of the light emitted from the third emitter E₃ and the light excited through the third color-determining layer 126. When the third color-determining layer 126 is a transparent light-transmitting layer, the transmitted light L3 may be the same as the light emitted from the third emitter E₃.

FIG. 9 to FIG. 10B shows a light emitting apparatus 100 according to yet another embodiment of the disclosed technology, which includes a substrate 110, a plurality of lower emitters D₁ to D_{N} disposed on the substrate 110 and configured to emit light, at least one upper emitter U₁ to U_{M} disposed on the lower emitters D₁ to D_{N} and configured to emit light, at least one color-determining layer F disposed on the plurality of lower emitters D₁ to D_{N}, and a barrier layer 130 surrounding the color-determining layer F.

The substrate 110 may have the same configuration as or a similar configuration to the substrate 110 of the light emitting apparatus 100 described above, and redundant description thereof will be omitted.

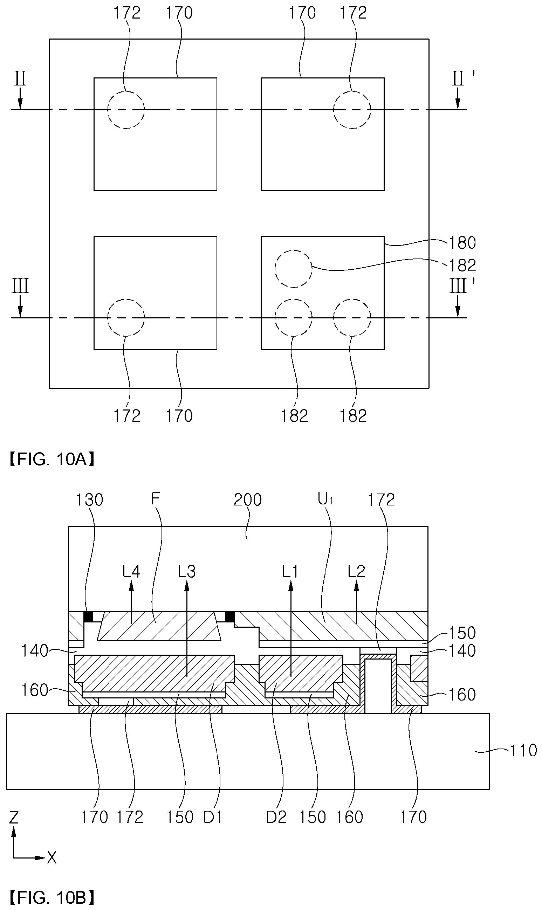

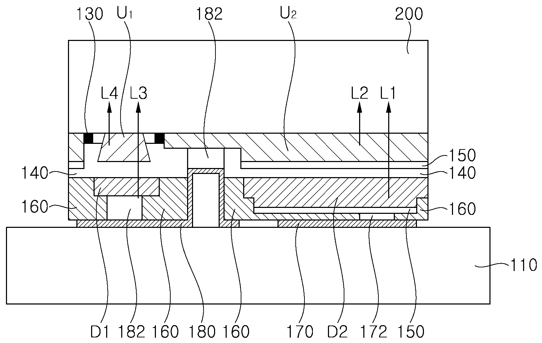

The plurality of lower emitters D₁ to D_{N} may be disposed on the substrate 110, may be configured to emit light, and may have the same configuration as or a similar configuration to the aforementioned emitters E₁ to E_{N}. For example, as shown in FIG. 10A, the light emitting apparatus 100 may include two emitters, that is, first and second lower emitters D1, D2.

The first lower emitter D1 may emit light having a first peak wavelength and the second lower emitter D2 may emit light having a second peak wavelength. The first peak wavelength and the second peak wavelength may be the same or different from each other.

For example, the first and second lower emitters D1, D2 may emit light in a wavelength band of 350 nm to 500 nm. Here, the first to third emitters E₁ to E₃ may emit blue light or ultraviolet light.

A difference between the peak wavelengths of the light emitted from the first and second lower emitters D1, D2 may be less than or equal to 5 nm. For the lower emitters D1, D2, a difference in indium content of the active layer may be less than or equal to 5%.

Referring to FIG. 10A, the lower emitters D1, D2 may be formed by a mesa MS formed by partially etching the second conductivity type semiconductor layer so as to expose the upper surface of the first conductivity type semiconductor layer. Each of the lower emitters D1, D2 may be isolated and driven through the mesa structure.

The upper emitters U₁ to U_{M} configured to emit light may be disposed on the lower emitters D₁ to D_{N} and may have the same configuration as or a similar configuration to the lower emitters D₁ to D_{N}. That is, the light emitting apparatus 100 shown in FIG. 9 to FIG. 10B differs from the light emitting apparatus 100 described with reference to FIG. 1 to FIG. 8 in that the upper emitters U₁ to U_{M} configured to emit light is disposed on the lower emitters D₁ to D_{N}.

For example, referring to FIG. 10A, the light emitting apparatus 100 may include one upper emitter U₁ disposed on the first lower emitter D1. The upper emitter U1 may be a light emitting structure configured to emit light having a specific peak wavelength and may have the same configuration as or a similar configuration to the lower emitters D₁ to D_{N}. The peak wavelength of the light emitted from the upper emitter U1 may be different from the peak wavelengths of the light emitted from the lower emitters D₁ to D_{N}. For example, the upper emitter U1 may emit green light.

Although FIG. 10A illustrates an example in which the light emitting apparatus 100 includes one upper emitter U1, it should be understood that the disclosed technology is not limited thereto. For the light emitting apparatus 100 including a plurality of upper emitters U₁ to U_{M}, the corresponding lower emitters D₁ to D_{N} may be disposed under the upper emitters U₁ to U_{M}, respectively.

The light emitting apparatus 100 may further include an ohmic electrode 150 disposed on one surface of each of the lower emitters D₁ to D_{N} and the upper emitters U₁ to U_{M}. The ohmic electrodes 150 may be transparent electrodes, such as ITO, IZO, or others. In addition, the ohmic electrodes 150 may be formed of a light-reflective metallic material. Here, the surface of each of the lower emitters D₁ to D_{N} and the upper emitters U₁ to U_{M} on which the ohmic electrode 150 is disposed may face the substrate 110.

In this embodiment, the light emitting apparatus 100 may further include a buffer layer 140 interposed between the lower emitter D₁ to D_{N} and the upper emitter U₁ to U_{M}. In addition, the light emitting apparatus 100 may further include a protective layer 160 that covers the ohmic electrodes 150 of the lower emitters D₁ to D_{N}.

The buffer layer 140 may include openings that expose the ohmic electrodes 150 of the upper emitters U₁ to U_{M}. In the respective openings of the buffer layer 140, first electrodes 172 and second electrodes 182 may be disposed to be connected to the ohmic electrodes 150 of the upper emitters U₁ to U_{M}.

The protective layer 160 may include openings that expose the ohmic electrodes 150 of the lower emitters D₁ to D_{N}. When the lower emitter D₁ to D_{N} is provided in plural, the opening may also be provided in plural and the number of openings corresponds to the number of lower emitters. In the respective openings of the protective layer 160, the first electrodes 172 and the second electrodes 182 may be disposed to be connected to the ohmic electrodes 150 of the lower emitters D₁ to D_{N}.

Referring now to FIG. 9 to FIG. 10B, the first electrode pad 180 and the second electrode pad 170 may cover at least a region of the protective layer 160 and may be electrically connected to the first and second electrodes 172, 182 through the openings in the protective layer 160, respectively.

Although FIG. 9 illustrates an example in which the second electrode pad 170 is separately provided on each of the upper and lower emitters D₁ to D_{N}, U₁ to U_{M} and the first electrode pad 180 is provided as a common electrode, it should be understood that the invention is not limited thereto.

The color-determining layer F is disposed above the plurality of lower emitters D₁ to D_{N} and may have the same configuration as or a similar configuration to the color-determining layers 122, 124, 126 shown in FIG. 1 to FIG. 8.

The barrier layer 130 may surround the color-determining layer F and may have the same configuration as or a similar configuration to the barrier layer 130 shown in FIG. 1 to FIG. 8. The barrier layer 130 may be spaced apart from or in close contact with the color-determining layer F.

Light emitted from at least one of the lower emitters D₁ to D_{N} may be emitted after passing through the upper emitters U₁ to U_{M}. Further, the light emitted from at least one of the lower emitters D₁ to D_{N} may be emitted after passing through the color-determining layer F.

Light emitted from the lower emitters D₁ to D_{N} disposed corresponding to a lower region of the color-determining layer F may excite the color-determining layer F to generate excitation light.

Specifically, referring to FIG. 9 to FIG. 10B, the light emitting apparatus 100 may include two lower emitters, that is, first and second lower emitters D1, D2, an upper emitter U₁ disposed on the first lower emitter D1, and a color-determining layer F disposed on the second lower emitter D2.

Light L1 emitted from the first lower emitter D1 may be emitted to the outside after passing through the upper emitter U₁. Here, the light L1 may be blue light or ultraviolet light.

Light L2 emitted from the upper emitter U₁ may be emitted to the outside without passing through another layer or emitter. Here, the light L2 may be green light.

Light L3 emitted from the second lower emitter D2 may be emitted to the outside after passing through the color-determining layer F. The light L3 may be blue light or ultraviolet light.

Excitation light L4 may be emitted from the color-determining layer F excited by the light L3 emitted from the second lower emitter D2. A mixture of the light L3 and the light L4 may be emitted from the color-determining layer F. Here, the color-determining layer F may include a red wavelength conversion material excited by the light L3 emitted from the second lower emitter D2.

Accordingly, one RGB pixel (PX) may be constituted by the upper and lower emitters D1, D2, U₁ and the color-determining layer F.

Although FIG. 10A and FIG. 10B illustrate an example in which the light emitting apparatus 100 includes the supporter 200, the supporter 200 may be omitted as an optional configuration. Furthermore, although the light emitting apparatus 100 is illustrated with the transparent layer 300 omitted, it is apparent that the light emitting apparatus 100 may further include the transparent layer 300.

Although some exemplary embodiments have been described herein with reference to the accompanying drawings, it should be understood that various modifications and changes can be made by those skilled in the art or by a person having ordinary knowledge in the art without departing from the spirit and scope of the disclosed technology, as defined by the claims and equivalents thereto.

Therefore, the scope of the disclosed technology should be defined only by the appended claims and equivalents thereto rather than by the detailed description of the disclosed technology.

## Claims

1. A light emitting apparatus (100) comprising:
a substrate (110);
a plurality of emitters (E₁ to E_{N}) disposed on the substrate (110) and configured to emit light;
at least one color-determining layer (122, 124, 126) disposed on the plurality of emitters (E₁ to E_{N}); and
a barrier layer (130) surrounding the color-determining layer (122, 124, 126).

2. The light emitting apparatus (100) according to claim 1, wherein the barrier layer (130) has at least one hole H and the color-determining layer (122, 124, 126) is disposed within the hole (H).

3. The light emitting apparatus (100) according to claim 1, wherein the barrier layer (130) has a plurality of holes (H) arranged in a grid pattern.

4. The light emitting apparatus (100) according to claim 1, wherein the plurality of emitters (E₁ to E_{N}) includes a first emitter (E₁) configured to emit light in a first wavelength band, a second emitter (E₂) configured to emit light in a second wavelength band, and a third emitter (E₃) configured to emit light in a third wavelength band.

5. The light emitting apparatus (100) according to claim 4, wherein the first to third emitters (E₁ to E₃) are configured to generate light in a wavelength band of 350 nm to 500 nm and a difference in peak wavelength of light emitted from the first to third emitters (E₁ to E₃) is less than or equal to 5 nm.

6. The light emitting apparatus (100) according to claim 4,
wherein each of the first to third emitters (E₁ to E₃) includes a first conductivity type semiconductor layer, a second conductivity type semiconductor layer, and an active layer interposed between the first conductivity type semiconductor layer and the second conductivity type semiconductor layer, and
wherein well layers of each of the active layers include the same material.

7. The light emitting apparatus (100) according to claim 4, wherein the color-determining layer (122, 124, 126) includes a first color-determining layer (122) disposed on the first emitter (E₁), a second color-determining layer (124) disposed on the second emitter (E₂), and a third color-determining layer (126) disposed on the third emitter (E₃),
wherein at least one of the first to third color-determining layers (122, 124, 126) includes a wavelength conversion material.

8. The light emitting apparatus (100) according to claim 7, wherein at least one of the first to third color-determining layers (122, 124, 126) is a transparent light-transmitting layer.

9. The light emitting apparatus (100) according to claim 4, wherein an upper surface of the color-determining layer (122, 124, 126) is flush with an upper surface of the adjacent barrier layer (130).

10. The light emitting apparatus (100) according to claim 9, wherein a width W₁ of the barrier layer (130) is less than a horizontal width W₂ of the adjacent color-determining layer (122, 124, 126).

11. The light emitting apparatus (100) according to claim 1, wherein the barrier layer (130) includes a first barrier layer (132) and a second barrier layer (134) disposed under the first barrier layer (132) and having a vertical height (H₁₂) greater than a vertical height (H₁₁) of the first barrier layer (132).

12. The light emitting apparatus (100) according to claim 11, wherein a width (W₁₂) of the second barrier layer (134) is less than a width (W₁₁) of the first barrier layer (132).

13. The light emitting apparatus (100) according to claim 11, wherein the first barrier layer (132) includes the same material as the second barrier layer (134).

14. The light emitting apparatus (100) according to claim 11, wherein the barrier layer (130) further includes a third barrier layer (136) disposed between the first barrier layer (132) and the color-determining layer (122, 124, 126).

15. The light emitting apparatus (100) according to claim 14, wherein the third barrier layer (136) is a metallic reflective layer.

16. The light emitting apparatus (100) according to claim 11, further comprising:
a buffer layer (140) disposed between the plurality of emitters (E₁ to E_{N}) and the color-determining layer (122, 124, 126).

17. The light emitting apparatus (100) according to claim 16, wherein a portion of the buffer layer (140) is disposed between the color-determining layer (122, 124, 126) and the barrier layer (130).

18. The light emitting apparatus (100) according to claim 4, further comprising:
an ohmic electrode (150) disposed on one surface of each of the first to third emitters (E₁ to E₃) facing the substrate (110),
wherein each of the ohmic electrodes (150) has the same shape or similar shapes.

19. A light emitting apparatus (100) comprising:
a substrate (110);
a plurality of lower emitters (D₁ to D_{N}) disposed on the substrate (110) and configured to emit light;
at least one upper emitter (U₁ to U_{M}) disposed on the lower emitters (D₁ to D_{N}) and configured to emit light; and
at least one color-determining layer (122, 124, 126) disposed on the plurality of lower emitters (D₁ to D_{N}); and
a barrier layer (130) surrounding the color-determining layer (122, 124, 126).

20. The light emitting apparatus (100) according to claim 19, wherein the upper emitter (U₁ to U_{M}) is configured to emit light in a wavelength band having a different peak wavelength than the plurality of lower emitters (D₁ to D_{N}).
